Europäisches Patentamt

European Patent Office

Office européen des brevets

(11) Veröffentlichungsnummer: **0 304 601**
**A2**

## EUROPÄISCHE PATENTANMELDUNG

(21) Anmeldenummer: **88111258.5**

(22) Anmeldetag: **13.07.88**

(51) Int. Cl.⁴: **H01S 3/133**

(30) Priorität: **25.08.87 DE 3728349**

(43) Veröffentlichungstag der Anmeldung:
**01.03.89 Patentblatt 89/09**

(84) Benannte Vertragsstaaten:
**DE FR GB NL**

(71) Anmelder: **Siemens Aktiengesellschaft Berlin und München**
**Wittelsbacherplatz 2**
**D-8000 München 2(DE)**

(72) Erfinder: **Ebberg, Alfred, Dipl.-Ing.**
**Surkenstrasse 2**
**D-4630 Bochum(DE)**

(54) **Verfahren zur Freqzuenzstabilisierung eines Halbleiterlasers mit angekoppeltem, externem Ringresonator.**

㊗ Es soll ein Verfahren zur Frequenzstabilisierung eines Halbleiterlasers (1) mit angekoppeltem, externem Ringresonator (2) angegeben werden, mit dem die Stabilisierung der Emissionsfrequenz des Halbleiterlasers (1) durch eine Stabilisierung des freien Spektralbereichs (FSR) und damit der Resonanzfrequenzen (f1, f2) des an den Laser (1) angekoppelten Ringresonators (2) unabhängig von Temperaturschwankungen erreicht werden kann.

Dazu wird der freie Spektralbereich (FSR) des Resonators (2) mit Hilfe einer Referenzfrequenz (rf) durch eine Verschiebung der Resonanzfrequenzen (f1, f2) des Resonators (2) mittels eines im Resonator (2) angeordneten Phasenmodulators (PM) laufend auf einen Sollwert (FSR0) geregelt.

Anwendung beim optischen Überlagerungsempfang

FIG 1

EP 0 304 601 A2

# Verfahren zur Frequenzstabilisierung eines Halbleiterlasers mit angekoppeltem, externem Ringresonator

Die Frequenzstabilität eines Halbleiterlasers, beispielsweise einer Halbleiter-Laserdiode, kann durch eine Stabilisierung sowohl des Injektionsstromes als auch der Kristalltemperatur derart gesteigert werden, daß sie für viele Anwendungen ausreichend ist. Die verbleibenden Frequenzschwankungen können jedoch bis zu einigen 100 MHz betragen. Werden höhere Anforderungen an die Frequenzkonstanz gestellt, so muß auf eine Stabilisierung mit Hilfe externer, frequenzstabiler Resonatoren zurückgegriffen werden.

Unter Verwendung von Monomode-Lichtleitfasern lassen sich Ringresonatoren realisieren, die sehr hohe Güte erreichen können (siehe dazu Optics Lett. 7 (June 1982) S. 288-290). Ihr Transmissions- und Reflexionsverhalten ist dem eines Fabry-Perot-Resonators sehr ähnlich, so daß Faser-Ringresonatoren unter anderem eingesetzt werden können, um die Emissionsfrequenz von Halbleiter-Laserdioden zu stabilisieren (siehe dazu Proc. of IOOC-ECOC 1985, S. 833-836). Da jedoch die Brechzahl einer Lichtleitfaser eine starke Temperaturabhängigkeit aufweist, reagieren Faser-Resonatoren auf Temperaturschwankungen mit einer großen Änderung ihrer Resonanzfrequenz, die auch mit einer Änderung des freien Spektralbereichs verbunden ist, der durch den Frequenzabstand zwischen zwei benachbarten Resonanzfrequenzen des Resonators definiert und gleich $c/n \cdot l$ ist, wobei $c$ die Vakuumlichtgeschwindigkeit, $n$ die Brechzwahl der eines ringförmig geschlossenen optischen Wellenleiters des Resonators sowie $l$ dessen Länge bedeuten. Die Frequenzkonstanz einer derart stabilisierten Laserdiode ist für viele Anwendungsfälle, beispielsweise für den optischen Heterodynempfang nicht ausreichend, so daß zusätzliche Stabilisierungsmaßnahmen ergriffen werden müssen.

Die Stabilisierung des freien Spektralbereichs und somit der Resonanzfrequenzen eines optischen Resonators wurde bisher durch eine Stabilisierung der Resonatorlänge erreicht. Diese erfolgt üblicherweise durch Realisierung eines temperaturkompensierten Aufbaus unter Verwendung von Invar- oder Quarzstäben. Bei einem Faser-Ringresonator wird jedoch die Frequenzstabilität im wesentlichen durch die relativ starke Temperaturabhängigkeit der Brechzahl der Faser bestimmt. Das Betreiben eines derartigen Resonators bei konstanter Umgebungstemperatur ist bisher die einzig bekannte Möglichkeit der Frequenzstabilisierung.

Aufgabe der Erfindung ist es, ein Verfahren der eingangs genannten Art anzugeben, mit dem die Stabilisierung der Emissionsfrequenz des Halbleiterlasers durch eine Stabilisierung des freien Spektralbereichs und damit der Resonanzfrequenzen des an den Laser angekoppelten Ringresonators unabhängig von Temperaturschwankungen erreicht werden kann.

Diese Aufgabe wird durch die im kennzeichnenden Teil des Patentanspruchs 1 angegebenen Merkmale gelöst.

Das erfindungsgemäße Verfahren wird zweckmäßigerweise so ausgeführt, wie es im Anspruch 2 angegeben ist.

Eine vorteilhafte Weiterbildung des Verfahrens nach Anspruch 2 ist im Anspruch 3 angegeben. Dieses Verfahren nach Anspruch 3 beruht auf der Tatsache, daß in einem Ringresonator zwei entgegengesetzt laufende Wellen unabhängig voneinander Resonanzerscheinungen zeigen, wobei die Resonanzfrequenzen übereinstimmen, solange die Lichtausbreitung in der Faser reziprok ist.

Die Ermittlung, ob die Frequenz der frequenzversetzten Welle oder/und die Frequenz der dazu entgegengesetzt laufenden anderen Welle mit den jeweils zugeordneten Resonanzfrequenzen übereinstimmen, kann nach Maßgabe des Anspruchs 4 erfolgen.

Zweckmäßigerweise wird dabei so vorgegangen, wie es im Anspruch 5 angegeben ist.

Die Erzeugung der frequenzversetzten Welle erfolgt vorzugsweise nach Maßgabe des Anspruchs 6.

Eine bevorzugte Ausgestaltung des Phasenmodulators ist im Anspruch 7 angegeben.

Ein Ausführungsbeispiel der Erfindung wird anhand der Figuren in der folgenden Beschreibung erläutert. Von den Figuren zeigen:

Figur 1 eine beispielhafte Vorrichtung zur Durchführung eines hier beschriebenen Verfahrens,

Figur 2 eine graphische Darstellung des Resonanzverhaltens des Resonators und

Figur 3 und Figur 4 jeweils einen Ausschnitt aus der Vorrichtung nach Figur 1, von denen jeder den zwischen dem Strahlteiler ST1 und dem Spiegel Sp angeordneten Frequenzversetzer mit dem steuernden Generator G1 zeigt, wobei der Frequenzversetzer in der Figur 3 ein akustooptischer Modulator in Form einer Braggzelle und in der Figur 4 ein faseroptischer Frequenzversetzer ist.

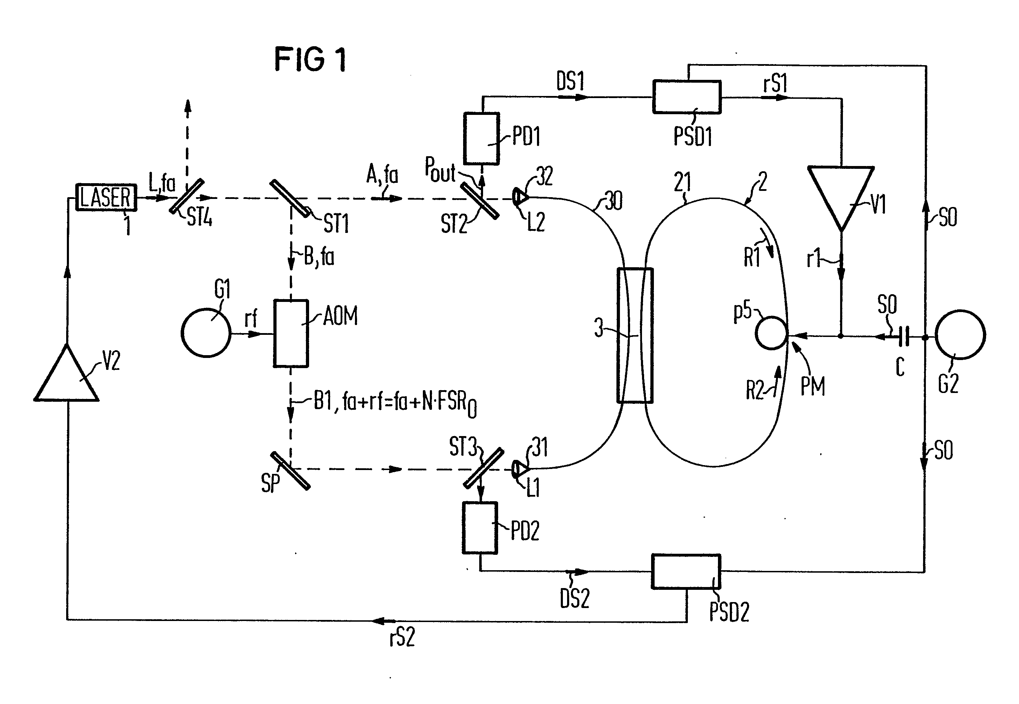

Die zentralen Teile der Vorrichtung nach Figur 1 sind ein Halbleiterlaser 1 und ein Ringresonator 2. Der Ringresonator 2 besteht aus einer ringförmig geschlossenen Monomodefaser 21 und aus einem optischen Richtkoppler 3 zum Ein- und Auskoppeln optischer Leistung in und aus dem Resonator 2.

Der optische Richtkoppler 3 ist so aufgebaut, daß eine zweite Monomodefaser 30 mit zwei Enden 31 und 32 eine bestimmte Strecke lang in geringem Abstand neben der ringförmig geschlossenen Faser 21 des Resonators 2 läuft, wobei der geringe Abstand so bemessen ist, daß in der bestimmten Strecke optische Leistung zwischen den beiden Fasern überkoppeln kann. Die Enden 31 und 32 der weiteren Monomodefaser dienen jeweils zum Ein- und/oder Auskoppeln optischer Leistung in bzw. aus dem Resonator 2.

Wird beispielsweise über das Ende 31 der weiteren Faser 30 optische Leistung eingekoppelt, so koppelt diese Leistung im Richtkoppler 3 zumindest teilweise in die ringförmig geschlossene Faser 21 über und läuft in der den Uhrzeigersinn anzeigenden Richtung R1 in dieser Faser 21 um. Diese umlaufende optische Leistung kann unter Umständen am Richtkoppler 3 wieder aus der Faser 21 ausgekoppelt und am anderen Ende 32 der weiteren Faser 30 entnommen werden.

Wieviel optische Leistung aus der ringförmig geschlossenen Faser ausgekoppelt wird, hängt von der Frequenz der eingekoppelten Leistung ab.

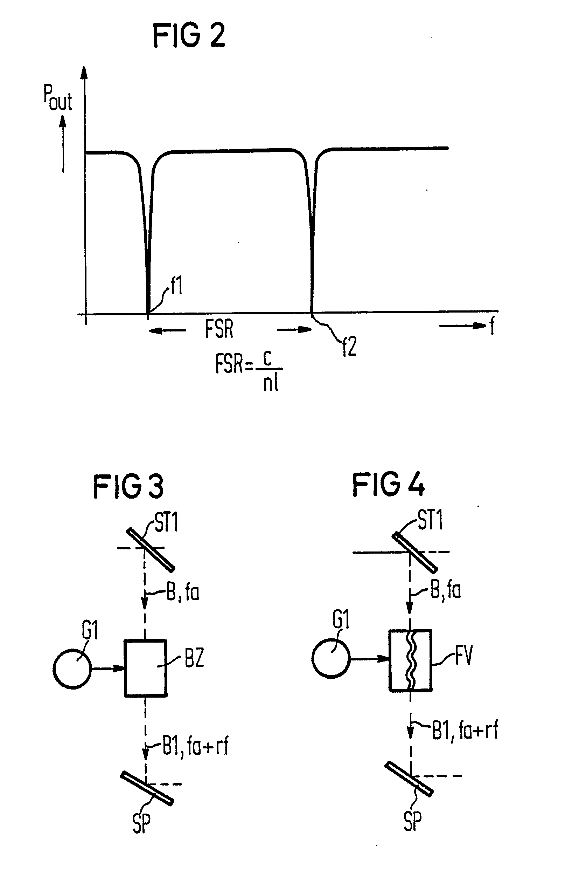

In der Figur 2 ist das Resonanzverhalten des Resonators 2 schematisch dargestellt. In dieser Figur 2 ist die am Ende 32 ausgekoppelte Leistung $p_{out}$ über der Frequenz f der am Ende 31 der Faser 30 eingekoppelten Leistung aufgetragen. Danach gibt es bestimmte Resonanzfrequenzen f1, f2 usw., bei denen die eingekoppelte Leistung eine Resonanz des Resonators 2 anregt. Dies bedeutet, daß über den Richtkoppler und das Ende 32 keine optische Leistung ausgekoppelt werden kann. Fällt dagegen die Frequenz der eingekoppelten Leistung in einen freien Spektralbereich FSR zwischen zwei benachbarten Resonanzfrequenzen f1 und f2 des Resonators 2, so regt diese Leistung keine Resonanz im Resonator an und sie kann über den Richtkoppler und das Ende 32 ganz oder zumindest teilweise ausgekoppelt werden.

Dasselbe gilt, wenn die optische Leistung über das Ende 32 der Faser 30 eingekoppelt, in der den Gegenuhrzeigersinn anzeigenden Richtung R2 in der Faser 21 umläuft und über den Richtkoppler 3 und das Ende 31 ausgekoppelt wird. Wie schon erwähnt, erzeugen zwei in der Faser 21 entgegengesetzt umlaufende Wellen unabhängig voneinander Resonanzerscheinungen, wobei die Resonanzfrequenzen f1 und f2 usw. für beide Wellen übereinstimmen, so lange die Lichtausbreitung in der Faser reziprok ist.

Es sei nun die Arbeitsweise der Vorrichtung nach Figur 1 näher beschrieben.

Eine vom monomodigen Halbleiterlaser 1 abgestrahlte optische Welle L der Frequenz fa wird zumindest teilweise einem ersten Strahlteiler ST1 zugeleitet, der diese Welle in eine Welle B der Frequenz fa und in eine andere Welle A der Frequenz fa aufspaltet.

Die eine Welle B wird einem akustooptischen Modulator AOM zugeleitet, der mit einem von einem Signalgenerator G1 erzeugten elektrischen Signal mit der Referenzfrequenz rf gesteuert wird, und der die Frequenz fa der Welle B um die Referenzfrequenz rf versetzt, so daß die aus dem akustooptischen Modulator AOM austretende Welle B1 eine um die Referenzfrequenz rf versetzte Frequenz fa + rf hat. Der Frequenzversetzer in Form des akustooptischen Modulators kann auch eine allgemein bekannte Bragg-Zelle BZ sein (siehe Figur 3). Anstelle eines Frequenzversetzers in Form eines akustooptischen Modulators kann vorteilhafterweise auch ein faseroptischer Frequenzversetzer FV (siehe Figur 4 und Electron. Lett., 9. Okt. 1986, Vol. 22, No. 21, S. 1141-1142 oder Opt. Lett., June 1986, Vol. 11, No. 6, S. 389-391) verwendet werden.

Die frequenzversetzte Welle B1 wird einer dem Ende 32 der Faser 30 gegenüberliegenden Einkoppellinse L1, beispielsweise über einen Umlenkspiegel SP und einen für eine Leistungsauskopplung erforderlichen Strahlteiler ST3, zugeleitet. Die Linse L1 fokussiert die frequenzversetzte Welle B1 auf das Ende 31 der Faser 30, so daß eine Einkopplung dieser Welle B1 in diese Faser erfolgt. Die eingekoppelte frequenzversetzte Welle B1 koppelt über den Richtkoppler 3 in die ringförmig geschlossene Faser 21 des Resonators 2 ein und läuft darin in Richtung R1 um.

Unter der Annahme, daß die Frequenz fa mit einer Resonanzfrequenz f1 des Resonators 2 übereinstimmt und dessen freier Spektralbereich FSR gleich dem Sollwert $FSR_0$ dieses Bereichs ist, regt die frequenzversetzte Welle B1 eine Resonanz im Resonator 2 an, wenn die Resonanzfrequenz rf auf rf = N·$FSR_0$ eingestellt ist, wobei N eine ganze Zahl ungleich 0 ist. Dies bedeutet, daß am Ende 32 der Faser 30 keine Leistung auskoppelbar ist. Im folgenden sei ohne Beschränkung der Allgemeinheit N = 1 angenommen.

Hat sich aufgrund einer Temperaturänderung das Resonanzverhalten des Resonators 2 geändert, so daß seine Resonanzfrequenzen f1 und f2 usw. verschoben sind und sein freier Spektralbereich FSR nicht mehr mit dem Sollwert $FSR_0$ übereinstimmt, so regen die Frequenzen fa und fa + rf keine Resonanzen im Resonator 2 an, wenn diese Änderungen ausreichend groß sind.

In diesem Fall ist dem Ende 32 der Faser 30 eine von dieser Welle B1 kommende optische Leistung entnehmbar, die mit einem optoelektrischen Detektor PD1, beispielsweise einer Photodiode, gemessen werden kann, und die eine Information über die Abweichung derjenigen Resonanzfrequenz f2 des Resonators 2 enthält, die der Frequenz fa + rf der frequenzversetzten Welle B1 am nächsten liegt und damit dieser Frequenz fa + rf zugeordnet ist. Wie schon angedeutet, weicht auch die Resonanzfrequenz f1 des Resonators 2 von der zugeordneten nächstliegenden Frequenz fa ab.

Die Abweichung der Resonanzfrequenz f2 von der zugeordneten Frequenz $fa+rf = fa+FSR_0$ kann mittels einer phasenempfindlichen Gleichrichtung und dem im Resonator 2 angeordneten Phasenmodulator PM ermittelt werden. Dazu wird ein Ausgangssignal DS1 des Detektors PD1 einem Lock-In-Verstärker PSD1 zugeleitet, dem ein elektrisches Signal So einer bestimmten Frequenz f0 aus einem Signalgenerator G2 als ein Referenzsignal zugeleitet ist, das zugleich den Phasenmodulator PM steuert, der beispielsweise eine spannungsgesteuerte piezoelektrische Scheibe pS sein kann, die einen von dem Referenzsignal So abhängigen Quetschdruck auf die Faser 21 ausübt. Das Ausgangssignal rS1 des Lock-In-Verstärkers PSD1, das die Abweichung der Referenzfrequenz f2 des Resonators 2 von der zugeordneten Frequenz $fa+rf$ angibt, kann einem Regelverstärker V1 als ein Regelsignal zugeleitet werden, dessen Ausgangssignal v1 den Phasenmodulator PM so steuert und damit das Resonanzverhalten des Resonators 2 so verändert, daß die Abweichung verschwindet, damit die Resonanzfrequenzen f1 und f2 wieder mit den zugeordneten Frequenzen fa bzw. $fa+rf$ übereinstimmen und dadurch der freie Spektralbereich FSR des Resonators gleich dem Sollwert $FSR_0$ ist. Auf diese Weise kann der freie Spektralbereich des Resonators 2 auf den genannten Sollwert $FSR_0$ geregelt werden.

Das Ausgangssignal v1 des Regelverstärkers V1 kann dem gleichen Eingang des Phasenmodulators PM zugeführt werden, wie das Referenzsignal So der bestimmten Frequenz f0 des Signalgenerators G2, wenn dieses Referenzsignal So dem Phasenmodulator PM über einen Entkoppelkondensator C zugeführt wird.

Es ist zweckmäßig, auch eine Abweichung der Resonanzfrequenz f1 des Resonators 2 von der zugeordneten Frequenz fa zu ermitteln, die zur Regelung des Halbleiterlasers 1 auf die Frequenz fa verwendet werden kann. Diese letztgenannte Abweichung kann auf die gleiche Weise wie die vorstehend genannte Abweichung durch eine phasenempfindliche Gleichrichtung und den Phasenmodulator PM ermittelt werden.

Dazu wird die andere Welle A der Frequenz fa über einen zur Leistungsauskopplung dienenden Strahlteiler ST2 einer Linse L2 zugeleitet, die diese andere Welle A auf das Ende 32 der Faser 30 fokussiert, so daß sie in diese Faser 30 eingekoppelt wird.

Diese eingekoppelte andere Welle A koppelt im Richtkoppler 3 zumindest teilweise in die ringförmig geschlossene Faser 21 des Resonators 2 über und läuft darin in der den Gegenuhrzeigersinn anzeigenden Richtung R2 um. Je nach dem, ob die in dieser Richtung R2 umlaufende Welle eine Resonanz im Resonator 2 anregt oder nicht, ist auch von dieser umlaufenden Welle über den Richtkoppler 3 und das Ende 31 der Faser 30 keine bzw. mehr oder weniger optische Leistung auskoppelbar. Eine am Ende 31 der Faser 30 ausgekoppelte Leistung enthält eine Information über eine Differenz zwischen der Frequenz fa der anderen Welle A und der ihr am nächsten liegenden und damit zugeordneten Resonanzfrequenz f1 des Resonators 2. Diese ausgekoppelte Leistung kann ebenfalls mit einem optoelektrischen Detektor PD2 gemessen werden.

Die Differenz zwischen der Frequenz fa der anderen Welle A und der zugeordneten Resonanzfrequenz f1 kann wieder mittels einer phasenempfindlichen Gleichrichtung und dem im Resonator 2 angeordneten Phasenmodulator PM ermittelt werden. Dazu wird beispielsweise ein Ausgangssignal DS2 des Detektors PD2 einem Lock-in-Verstärker PSD2 zugeleitet, dem ebenfalls das Signal So des Generators G2 als ein Referenzsignal zugeleitet ist. Ein Ausgangssignal rS2 des Lock-in-Verstärkers PSD2, das die Differenz zwischen der Frequenz fa und der zugeordneten Resonanzfrequenz f1 des Resonators 2 angibt, kann einem Regelverstärker V2 als ein Regelsignal zugeleitet werden, dessen Ausgangssignal v2 den Halbleiterlaser 1 so regelt, daß die genannte Differenz verschwindet und die Frequenz fa mit der zugeordneten Resonanzfrequenz übereinstimmt.

Die beiden Strahlteiler ST2 und ST3 dienen lediglich dazu, daß den Enden 31 und 32 der Faser 30 optische Leistung zuleitbar ist, und daß unabhängig davon aus diesen Enden 31 und 32 ausgekoppelte Leistung den Detektoren PD1 bzw. PD2 zuleitbar ist.

Der Strahlteiler ST4 ist nur notwendig, wenn der Resonator 2 auf der Seite des Lasers 1 angeordnet ist, auf die der Laserleistung, d. h. die Welle L entnommen wird. Ist der Resonator 2 auf der von dieser Seite abgekehrten Seite des Lasers 1 angeordnet, wird ein Strahlteiler ST4 nicht benötigt.

Die Strahlteiler ST1 bis ST4 sind in der Vorrichtung nach Figur 1 teildurchlässige, schräg zur Ausbreitungsrichtung des Lichts angeordnete Spiegel. Sie können vorteilhafterweise auch durch optische Richtkoppler, insbesondere Lichtleitfaser-Richtkoppler, realisiert werden. Vorteilhaft ist es auch, die ringförmig geschlossene Faser 2, den Richtkoppler 3 und auch die Strahlteiler in Form von Richtkopplern aus polarisationserhaltender Monomodelichtleitfaser herzustellen.

Bei der Vorrichtung nach Fig. 1 und generell bei einer erfindungsgemäßen Vorrichtung ist der Grad der Stabilisierung im wesentlichen durch die Unsicherheit Δf bei der Messung des freien Spektralbereichs FSR, d. h. des Frequenzabstandes zwischen zwei benachbarten Resonanzfrequenzen des Resonators bestimmt. Theoretisch lassen sich Werte $\Delta f$ erreichen, die etwa 0,1 Hz betragen; experimentell konnten bisher Resonanzfrequenzen mit einer Unsicherheit $\Delta f$ von ungefähr 2 Hz bestimmt werden (siehe dazu R. E. Meyer, S. Ezekiel, D. W. Stowe, V. J. Tekippe: Passive fiber-optic ring resonator for rotation sensing. Optics Letters, 8 (Dec. 83), 644-646). Die Unsicherheit $\delta f$ in der Resonanzfrequenz ergibt sich dann zu

$$\delta f = \Delta f \cdot \frac{fa}{N \cdot FSR}$$

mit $fa = 2 \cdot 10^{14}$ Hz (dies entspricht einer Wellenlänge von 1,5 $\mu$m) sowie $N \cdot FSR = 100$ MHz und $\Delta f = 1$ Hz ergibt sich $\delta f$ zu

$\delta f = 2$ MHz

ohne diese aktive Stabilisierung ergibt sich $\delta f$ zu

$\delta f = 2$ GHz$/°$K

hierbei wurde der Temperaturkoeffizient $dn/dT$ der Brechzahl $n$ eines Wellenleiters des Resonators zu

$dn/dT = 10^{-5}/°$K

angenommen (siehe dazu D. M. Shupe: Thermally induced nonreciprocity in the fiber-optic interferometer. Applied Optics, 19 (March 80), 654-655). Die Unsicherheit $\delta f$ bei einer aktiven Stabilisierung des freien Spektralbereichs ist klein genug, um z. B. Halbleiter-Laserdioden in einem optischen Heterodynsystem, ohne Regelung über das Zwischenfrequenzsignal, ausreichend gut stabilisieren zu können.

**Ansprüche**

1. Verfahren zur Frequenzstabilisierung eines Halbleiterlasers (1) mit angekoppeltem, externem Ringresonator (2), wobei zur Frequenzstabilisierung des Lasers Resonanzfrequenzen (f1, f2) des Resonators (2) stabilisiert werden, **dadurch gekennzeichnet,** daß zur Stabilisierung der Resonanzfrequenzen (f1, f2) der freie Spektralbereich (FSR) des Resonators (2) stabilisiert wird, indem mit Hilfe einer einem Sollwert (FSR₀) des freien Spektralbereichs (FSR) oder einem ganzzahligen Vielfachen dieses Wertes (FSR₀) entsprechenden Referenzfrequenz (rf) durch eine Verschiebung der Resonanzfrequenzen (f1, f2) des Resonators (2) mittels eines im Resonators (2) angeordneten Phasenmodulators (PM) laufend auf den Sollwert (FSR₀) geregelt wird.

2. Verfahren nach Anspruch 1, **dadurch gekennzeichnet,** daß die zumindest in der Nähe einer zugeordneten Resonanzfrequenz (f1) liegende Frequenz (fa) einer vom Laser (1) abgestrahlten Welle (B) um die Referenzfrequenz (rf) versetzt, die frequenzversetzte Welle (B1) in den Ringresonator (2) eingekoppelt und ermittelt wird, ob diese im Resonator in einer Richtung (R2) umlaufende Welle (B), deren versetzte Frequenz (fa + rf) in der Nähe einer zugeordneten anderen Resonanz (f2) des Resonators (2) liegt, eine Resonanz des Resonators (2) anregt oder nicht, wobei im Fall des Nichtanregens dieser Resonanz die Resonanzfrequenzen (f1, f2) mittels des Phasenmodulators (PM) verschoben werden, bis die zugeordnete andere Resonanzfrequenz (f2) und die verschobene Frequenz (fa + rf) übereinstimmen und dadurch eine Resonanz angeregt wird.

3. Verfahren nach Anspruch 2, **dadurch gekennzeichnet,** daß eine vom Laser (1) abgestrahlte andere Welle (A) mit der zumindest in der Nähe der zugeordneten einen Resonanzfrequenz (f1) des Resonators (2) liegenden Frequenz (fa) so in den Resonator (2) eingekoppelt wird, daß sie entgegengesetzt zur frequenzverschobenen Welle (B1) im Resonator (2) umläuft, daß ermittelt wird, ob die entgegengesetzt umlaufende andere Welle (A) eine Resonanz des Resonators (2) anregt oder nicht und daß bei Nichtanregen dieser Resonanz die Frequenz (fa) der anderen Welle (A) durch Regelung des Lasers (1) so verschoben wird, daß sie mit der zugeordneten einen Resonanzfrequenz (f1) des Resonators (2) übereinstimmt.

4. Verfahren nach Anspruch 2 oder 3, **dadurch gekennzeichnet,** daß die Ermittlung, ob die Frequenz (fa + rf) der frequenzversetzten Welle (B1) oder/und die Frequenz (fa) der anderen Welle (A) und die jeweils zugeordnete Resonanzfrequenz (f2 bzw. f1) übereinstimmen oder nicht mit Hilfe eines im Resonator (2) angeordneten Phasenmodulators (PM) und einer phasenempfindlichen Gleichrichtung von Detektorsignalen (DS1, DS2) erfolgt, von denen eines (DS1) einem aus dem Resonator (2) auskoppelbaren Leistungsanteil der in der einen Richtung (R1) umlaufenden, frequenzversetzten Welle (B1) und das andere (DS1) einem aus dem Resonator (2) auskoppelbaren Leistungsanteil der in der entgegengesetzten Richtung (R2) umlaufenden anderen Welle (A) entspricht, wobei ein zur phasenempfindlichen Gleichrichtung erforderliches Referenzsignal (So) bestimmter konstanter Frequenz (f0) den Phasenmodulator (PM) steuert.

5. Verfahren nach Anspruch 4, **dadurch gekennzeichnet,** daß zur Verschiebung der Resonanzfrequenzen (f1, f2) des Ringresonators (2) und zur Ermittlung, ob die Frequenzen der frequenzversetzten Welle (B1) oder/und der anderen Welle (A) mit den jeweils zugeordneten Resonanzfrequenzen (f2 bzw. f1) übereinstimmen ein und derselbe Phasenmodulator (PM) verwendet wird, wobei das Referenzsignal (So) bestimmter konstanter Frequenz (f0) dem Phasenmodulator (PM) über einen Entkoppelkondensator (C) zugeleitet wird.

6. Verfahren nach einem der Ansprüche 2 bis 5, **dadurch gekennzeichnet,** daß die Frequenz (f0) der vom Laser (1) abgestrahlten einen Welle (B) mittels eines akustooptischen Modulators (AOM) um die Referenzfrequenz (rf) frequenzversetzt wird.

7. Verfahren nach einem der Ansprüche 3 bis 6. **dadurch gekennzeichnet,** daß die Frequenz (f0) der vom Laser (1) abgestrahlten einen Welle (B) mittels einer Bragg-Zelle (BZ) um die Referenzfrequenz (rf) frequenzversetzt wird.

8. Verfahren nach einem der Ansprüche 2 bis 7. **dadurch gekennzeichnet,** daß die Frequenz (fo) der vom Laser (1) abgestrahlten einen Welle (B) mittels eines faseroptischen Frequenzversetzers (FV) um die Referenzfrequenz (rf) frequenzversetzt wird.

9. Verfahren nach einem der vorhergehenden Ansprüche, **dadurch gekennzeichnet,** daß der Phasenmodulator (PM) aus einem piezoelektrischen Stellglied besteht, das auf einen ringförmig geschlossenen optischen Wellenleiter (21) des Ringresonators (2) einwirkt.

# FIG 1

EP 0 304 601 A2

## FIG 2

$$FSR = \frac{c}{nl}$$

## FIG 3

## FIG 4